Europäisches Patentamt

European Patent Office

Office européen des brevets

(11) Veröffentlichungsnummer: **0 026 840**
**B1**

(12) **EUROPÄISCHE PATENTSCHRIFT**

(45) Veröffentlichungstag der Patentschrift:
**12.10.83**

(21) Anmeldenummer: **80105166.5**

(22) Anmeldetag: **29.08.80**

(51) Int. Cl.³: **H 04 L 17/02**, G 06 F 3/02

(54) **Schaltungsanordnung zum Umsetzen von Zeichen, die mittels einer Tastatur eingebbar sind, in Codezeichen, insbesondere Fernschreibzeichen.**

(30) Priorität: **18.09.79 DE 2937725**

(43) Veröffentlichungstag der Anmeldung:
**15.04.81 Patentblatt 81/15**

(45) Bekanntmachung des Hinweises auf die Patenterteilung:
**12.10.83 Patentblatt 83/41**

(84) Benannte Vertragsstaaten:
**BE CH FR IT LI NL SE**

(56) Entgegenhaltungen:
**DE-A-2 234 323**
**DE-A-2 832 637**
**DE-C- 542 864**

(73) Patentinhaber: **SIEMENS AKTIENGESELLSCHAFT,
Berlin und München Wittelsbacherplatz 2,
D-8000 München 2 (DE)**

(72) Erfinder: **Wiesner, Wolfgang, Dipl.-Ing., Sonnenleite 19,
D-8034 Germering (DE)**

ACTORUM AG

## Schaltungsanordnung zum Umsetzen von Zeichen, die mittels einer Tastatur eingebbar sind, in Codezeichen, insbesondere Fernschreibzeichen

Die Erfindung bezieht sich auf eine Schaltungsanordnung zum Umsetzen von Zeichen, die mittels einer Tastatur eingebbar sind, in Codezeichen, insbesondere Fernschreibzeichen.

Nach internationaler Vereinbarung sind nach dem CCITT-Code Nr. 2 codierte Fernschreibzeichen einige Sonderzeichen und Symbole nicht zugelassen und können damit nicht übertragen werden. Um dennoch Sonderzeichen, wie beispielsweise die Umlaute ä, ö und ü, übertragen zu können, ist es bereits bekannt, diese als Doppelzeichen, nämlich als ae, oe und ue, darzustellen.

Aus der DE-C2-2 542 864 ist eine Schaltungsanordnung bekannt, die für die Ausgabe von derartigen Doppelzeichen nach dem Betätigen einer entsprechenden Taste an einer Tastatur geeignet ist. Diese bekannte Schaltungsanordnung enthält einen Zähler, der zeitlich nacheinander unter Verwendung eines Decodierers und eines Multiplexers die Betätigung von matrixförmig angeordneten Tasten prüft. Wenn eine Taste betätigt wurde, wird der entsprechende Zählerstand in einen Speicher übernommen. Wenn eine Taste betätigt wird, die einem Doppelzeichen zugeordnet ist, wird die Übernahme des Zählerstands gesperrt und statt dessen wird gewartet, bis diejenigen Zählerstände auftreten, die den Codezeichen der Doppelzeichen zugeordnet sind. Bei der Verwendung von im Handel erhältlichen Tastaturbausteinen, die nach jeder Betätigung einer Taste der Tastatur vorgegebene Signale abgeben, ist diese bekannte Schaltungsanordnung für eine Erzeugung von Mehrfachzeichen nicht geeignet.

Der Erfindung liegt daher die Aufgabe zugrunde, eine leicht an beliebige Tastaturen anpassbare Schaltungsanordnung zum Umsetzen von mittels einer Tastatur eingegebenen Zeichen in Codezeichen, insbesondere Fernschreibzeichen, anzugeben, der von einer Tastatur bzw. einem Tastaturbaustein abgegebene Signale zugeführt werden und die in Abhängigkeit von den Zeichen einzelne oder eine Mehrzahl von Codezeichen abgibt.

Erfindungsgemäss wird die Aufgabe bei der Schaltungsanordnung der eingangs genannten Art dadurch gelöst, dass ein mit der Tastatur verbundener ersten Speicher vorgesehen ist, der für jedes Zeichen ein Datenwort enthält, in dem bei einem durch ein Codezeichen unmittelbar darstellbaren Zeichen dieses Codezeichen enthalten ist und in dem für jedes Sonderzeichen oder Symbol, für das kein Codezeichen vorhanden ist, ein Adressenwort enthalten ist, dass ein zweiter Speicher vorgesehen ist, an dem das Adressenwort anliegt und in dem für jedes Sonderzeichen oder Symbol mehrere weitere Datenwörter gespeichert sind, die dieses Zeichen beschreibende Codezeichen enthalten, und dass eine Schaltstufe vorgesehen ist, die bei der Eingabe eines Zeichens entweder das in dem Datenwort enthaltene Codezeichen oder die in den weiteren Datenwörten enthaltene Mehrzahl von Codezeichen zu einer Steuereinheit durchschaltet.

Die Schaltungsanordnung hat den Vorteil, dass sie eine einfache Struktur aufweist und einen geringen Aufwand erfordert. Die Schaltungsanordnung hat weiterhin den Vorteil, dass auch Sonderzeichen und insbesondere Symbole in verständlicher Weise übertragbar sind.

Die Schaltungsanordnung erfordert insbesondere dann einen geringen Aufwand, wenn der erste Speicher für die Datenwörter und der zweite Speicher für die weiteren Datenwörter Bestandteile einer einzigen Speichereinheit sind. Zweckmässigerweise werden diese Speicher bzw. die Speichereinheit als Festwertspeicher ausgebildet. Eine Änderung der Codezeichen wird dabei insbesondere dann in vorteilhafter Weise erreicht, wenn die Festwertspeicher als programmierbare Festwertspeicher ausgebildet sind.

Ein vorteilhafter Aufbau der Schaltungsanordnung wird auch dann erreicht, wenn die Speicher und die Schaltstufe Bestandteile eines Mikrorechners sind.

Zur Unterscheidung, ob die Schaltstufe die in den Datenwörtern oder den weiteren Datenwörtern enthaltenen Codezeichen zur Steuereinheit durchschalten soll, ist es zweckmässig, wenn die Datenwörter ein Binärzeichen enthalten, das jedes Zeichen kennzeichnet, für das kein Codezeichen zur Verfügung steht.

Falls für den zweiten Speicher ein Speicher zur Verfügung steht, in dem verhältnismässig lange Datenwörter speicherbar sind, ist es günstig, wenn jedes der weiteren Datenwörter die Mehrzahl von Codezeichen enthält. Andernfalls ist es von Vorteil, wenn jedes der weiteren Datenwörter ein Codezeichen enthält. In diesem Fall enthalten die weiteren Datenwörter zweckmässigerweise ein Binärzeichen, das das jeweils letzte zu einem Zeichen gehörende weitere Datenwort kennzeichnet.

Für die Verarbeitung von Steuerzeichen, die keine Zeichen darstellen, ist es günstig, wenn vorgegebene Kombinationen von Binärzeichen in den Datenwörtern die Steuerzeichen kennzeichnen und wenn die Schaltstufe beim Auftreten dieser Kombinationen mindestens einen Teil der von der Tastatur abgegebenen Signale unter Umgehung der Speicher zur Steuereinheit durchschaltet.

Im folgenden wird ein Ausführungsbeispiel der Schaltungsanordnung anhand von Zeichnungen erläutert.

Es zeigen:

Fig. 1 ein Blockschaltbild der Schaltungsanordnung,

Fig. 2 einen Teil einer tabellarischen Darstellung von in einem ersten Speicher enthaltenen Datenwörtern,

Fig. 3 eine tabellarische Darstellung von in einem zweiten Speicher gespeicherten weiteren Datenwörtern.

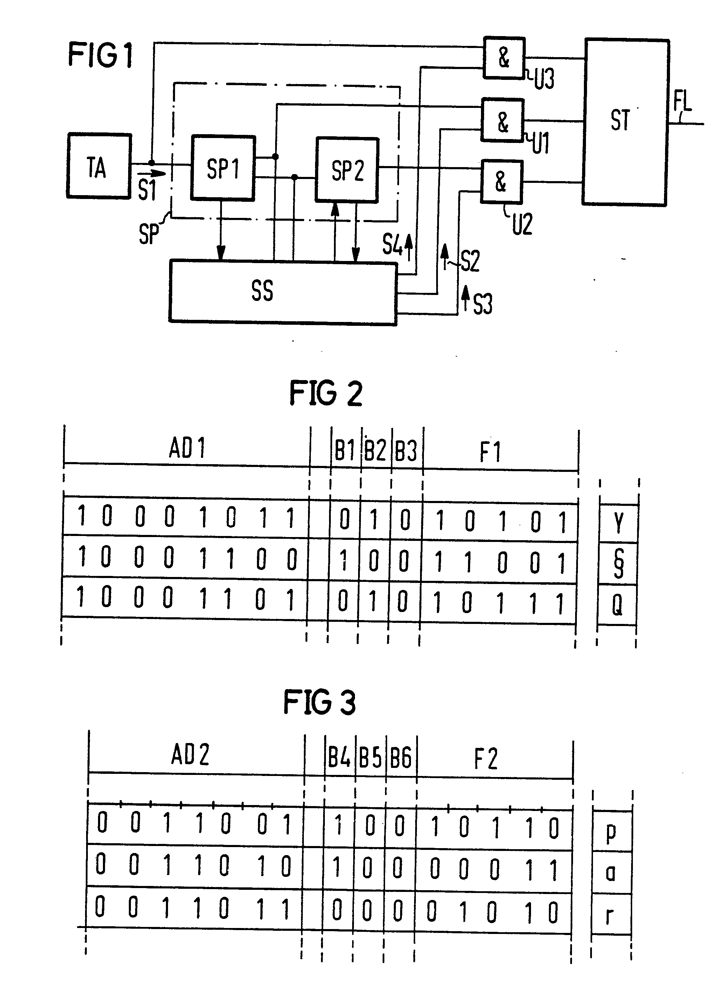

Die in Fig. 1 dargestellte Schaltungsanordnung stellt einen Teil einer Schreibstation, beispielsweise einer Fernschreibmaschine, dar. Mit Hilfe einer an der Schreibstation vorgesehenen Tastatur TA werden Zeichen eingegeben, die über eine Fernleitung FL zu einer weiteren Schreibstation übertragen werden sollen. Die Tastatur TA erzeugt Signale S1, die jeweils einer betätigten Taste an der Tastatur zugeordnet sind. Die Signale S1 werden einer Speichereinheit SP zugeführt, die zwei, vorzugsweise als Festwertspeicher ausgebildete Speicher SP1 und SP2 enthält.

Wenn die Signale S1 ein Zeichen darstellen, das durch ein über die Fernleitung FL übertragbares Codezeichen, beispielsweise ein nach dem CCITT-Code Nr. 2 codiertes Fernschreibzeichen, übertragbar ist, wird aus dem Speicher SP1 ein Datenwort ausgelesen, das dieses Codezeichen enthält.

Die Signale S1 dienen dabei als Adresse zum Adressieren des Datenworts. Neben dem Codezeichen enthält das Datenwort Binärzeichen, die die Buchstaben-/Ziffernlage kennzeichnen, die die Normal-/Shiftlage kennzeichnen und die angeben, ob es sich bei dem Zeichen um ein Zeichen handelt, das durch ein Codezeichen darstellbar ist. Eine Schaltstufe SS wertet diese Binärzeichen aus und da es sich im vorliegenden Fall um ein Zeichen handelt, das durch ein Codezeichen darstellbar ist, gibt die Schaltstufe SS ein Signal S2 an UND-Glieder U1, die das in dem Datenwort enthaltene Codezeichen zu einer Steuereinheit ST durchschaltet.

Falls die Signale S1 ein Zeichen darstellen, beispielsweise ein Sonderzeichen, wie ä, ö, ü, oder ein Symbol, wie beispielsweise §, % oder &, das nicht durch ein Codezeichen darstellbar ist, enthält das entsprechende im Speicher SP1 gespeicherte Datenwort anstelle des Codezeichens ein Adressenwort, dass dem Speicher SP2 zugeführt wird. Die Schaltstufe SS erkennt an dem entsprechenden Binärzeichen des Datenworts, dass es sich um ein derartiges Zeichen handelt. Unter der durch dieses Adressenwort dargestellten Adresse sind im Speicher SP2 mehrere Datenwörter gespeichert, die Codezeichen enthalten, die das Sonderzeichen oder das Symbol beschreiben. Beispielsweise wird das Sonderzeichen ä durch die Codezeichen für ae beschrieben oder das Symbol § wird durch die Codezeichen für die Buchstaben par beschrieben. Unter Steuerung durch die Schaltstufe SS werden aus dem Speicher SP2 die entsprechenden Datenwörter ausgelesen, und die Codezeichen werden mit Hilfe eines Signals S3 über UND-Glieder U2 zur Steuereinheit ST durchgeschaltet. Die im Speicher SP2 gespeicherten weiteren Datenwörter enthalten wieder Binärzeichen, die die Buchstaben-/Ziffernebene und die Normal-/Shiftebene kennzeichnen. Ein weiteres Binärzeichen hat immer einen ersten Binärwert, solange für die Darstellung des Zeichens noch weitere Datenwörter erforderlich sind. Wenn dieses Binärzeichen einen zweiten Binärwert hat, wird der Schaltstufe SS mitgeteilt, dass dieses Datenwort das letzte Codezeichen für die Darstellung des auszusendenden Zeichens enthält.

Falls mittels der Tastatur Steuerzeichen eingegeben werden, die keine zu übertragenden Zeichen darstellen, wird an den entsprechenden Stellen im Speicher SP1 jeweils ein Datenwort eingespeichert, das nur Binärwerte 1 enthält. Diesen Fall schaltet die Schaltstufe SS durch Signale S4 mindestens einen Teil der Signale S1 über UND-Glieder U3 zur Steuereinheit ST durch.

Weitere Einzelheiten werden zusammen mit den in Fig. 2 und Fig. 3 dargestellten Tabellen beschrieben. Bei der in Fig. 2 dargestellten Tabelle, die die Adresse und die Datenwörter im Speicher SP1 darstellt, entsprechen die Adressen AD1 den von der Tastatur abgegeben Signalen S1. Beispielsweise stellen die Signale S1 mit den Binärwerten 10001011 das Zeichen Y dar. Die Signale S1 bilden die Adresse AD1. Unter der Adresse ist im Speicher SP1 als Datenwort eine binäre Zeichenfolge gespeichert, die sich aus den Binärzeichen B1 bis B3 und den Binärzeichen F1 zusammensetzt, die das Zeichen Y entsprechend dem CCITT-Code Nr. 2 darstellen. Wenn an der Tastatur TA die Taste für das Zeichen Y betätigt wird, wird unter der als Signale S1 dargestellten Adresse das Datenwort 01010101 ausgelesen. Das Binärzeichen B1 gibt durch seinen Binärwert 0 an, dass es sich um ein Zeichen handelt, das durch ein Codezeichen darstellbar ist. Das Binärzeichen B2 gibt durch seinen Binärwert 1 an, dass es sich bei dem Zeichen Y um einen in der Shiftlage der Tastatur eingegeben Grossbuchstaben handelt. Das Binärzeichen B3 gibt durch seinen Binärwert 0 an, dass es sich um ein in der Buchstabenebene codiertes Codezeichen handelt. Die Binärzeichen F1 stellen, wie bereits gesagt, das Codezeichen für den Buchstaben Y dar. Ein dem Binärzeichen B1 zugeordnetes Signal wird der Schaltstufe SS zugeführt, und diese schaltet durch die Signale S2 die Binärzeichen F1 zur Steuereinheit durch.

Wenn an der Tastatur TA die Taste für Das Symbol § betätigt wird, nehmen die Signale S1 die Binärwerte 10001100 an. Unter dieser Adresse AD1 ist im Speicher SP1 das Datenwort mit den Binärzeichen 10011001 gespeichert. Das Binärzeichen B1 gibt in diesem Fall an, dass es sich um ein Zeichen handelt, das nicht durch ein Codezeichen darstellbar ist. Die Binärzeichen F1, B3 und B2 stellen in diesem Fall jedoch kein Codezeichen dar, sondern bilden ein Adressenwort, das dem Speicher SP2 zugeführt wird.

Bei dem Speicher SP2 ist unter der aus den Binärzeichen F1, B3 un B2 gebildeten Adresse AD2 011001 ein Datenwort gespeichert, das die Binärwerte 10010110 aufweist. Bei diesem Datenwort kennzeichnet ein Binärzeichen B4 durch seinen Binärwert 1, dass noch weitere Datenwörter so lange ausgelesen werden müssen, bis an dieser Stelle der Binärwert 0 auftritt. Die Binärzeichen B5 und B6 entsprechen den Binärzeichen B2 und B3 und die Binärzeichen F2 stellen wieder Codezeichen in Form von Fernschreibzeichen dar. Wenn das Datenwort aufgerufen wird, werden die Binärzeichen F2, die dem Buchstaben p zugeordnet sind, zur Steuereinheit ST2 übertragen. Da das Binärzeichen B4 den Binärwert 1 hat, wird aus dem Speicher SP2 auch das nächstfolgende Datenwort ausgelesen, dessen Binärzeichen F2 den Buchstaben a darstellen. Da auch in diesem Datenwort das Binärzeichen B4 den Binärwert 1 hat, wird auch noch das nächstfolgende Datenwort ausgelesen, dessen Binärzeichen F2 das Zeichen r darstellen. Dieses Datenwort enthält ein Binärzeichen B4 mit dem Binärwert 0, wodurch der Schaltstufe SS angezeigt wird, dass alle Datenwörter, die das Symbol § beschreiben, aus dem Speicher SP2 ausgelesen wurden. Anstelle des Symbols § wurden damit die Codezeichen für die Buchstaben «par» übertragen, mit denen das Symbol § beschrieben wird.

In entsprechender Weise werden durch die Schaltungsanordnung anstelle der in der folgenden Tabelle angegebenen Zeichen auf den Tasten der Tastatur die Codezeichen für die angegebenen Zeichen zur Steuereinheit ST übertragen.

| Zeichen auf Taste | Abgedruckte Zeichen |
|---|---|
| ä | ae |
| ö | oe |
| ü | ue |
| ß (Eszet) | ss |
| ° (Grad) | deg |
| µ | my |
| § | par |
| $ | dol |
| % | o/o |
| # | no |
| ² (hoch 2) | exp 2 |
| ³ (hoch 3) | exp 3 |
| £ | stg |

**Patentansprüche**

1. Schaltungsanordnung zum Umsetzen von Zeichen, die mittels einer Tastatur eingebbar sind, in Codezeichen, insbesondere Fernschreibzeichen, dadurch gekennzeichnet, dass ein mit der Tastatur (TA) verbundener erster Speicher (SP1) vorgesehen ist, der für jedes Zeichen ein Datenwort (B1, B2, B3. F1) enthält, im dem bei einem durch ein Codezeichen unmittelbar darstellbaren Zeichen dieses Codezeichen (F1) enthalten ist und in dem für jedes Sonderzeichen oder Symbol, für das kein Codezeichen vorhaden ist, ein Adressenwort (AD2) enthalten ist, dass ein zweiter Speicher (SP2) vorgesehen ist, an dem das Adressenwort (AD2) anliegt und in dem für jedes Sonderzeichen oder Symbol mehrere weitere Datenwörter (B4, B5, B6, F2) gespeichert sind, die dieses Zeichen beschreibende Codezeichen (F2) enthalten, und dass eine Schaltstufe (SS) vorgesehen ist, die bei der Eingabe eines Zeichens entweder das in dem Datenwort (B1, B2, B3, F1) enthaltene Codezeichen (F1) oder die in den weiteren Datenwörtern (B4, B5, B6, F2) enthaltene Mehrzahl von Codezeichen (F2) zu einer Steuereinheit (ST) durchschaltet.

2. Schaltungsanordnung nach Anspruch 1, dadurch gekennzeichnet, dass der erste Speicher (SP1) für die Datenwörter (B1, B2, B3, F1) und der zweite Speicher (SP2) für die weiteren Datenwörter (B4, B5, B6, F2) Bestandteile einer einzigen Speichereinheit (SP) sind.

3. Schaltungsanordnung nach Anspruch 1 oder Anspruch 2, dadurch gekennzeichnet, dass die Speicher (SP1, SP2) als Festwertspeicher ausgebildet sind.

4. Schaltungsanordnung nach einem der Ansprüche 1 bis 3, dadurch gekennzeichnet, dass die Speicher (SP1, SP2) und die Schaltstufe (SS) Bestandteile eines Mikrorechners sind.

5. Schaltunganordnung nach einem der Ansprüche 1 bis 4, dadurch gekennzeichnet, dass die Datenwörter (B1, B2, B3, F1) ein Binärzeichen (B1) enthalten, das jedes Zeichen kennzeichnet, für das kein Codezeichen zur Verfügung steht.

6. Schaltungsanordnung nach einem der Ansprüche 1 bis 5, dadurch gekennzeichnet, dass jedes der weiteren Datenwörter (B4, B5, B6, F2) eine Mehrzahl von Codezeichen enthält.

7. Schaltungsanordnung nach einem der Ansprüche 1 bis 5, dadurch gekennzeichnet, dass jedes der weiteren Datenwörter (B4, B5, B6, F2) ein Codezeichen (F2) enthält.

8. Schaltungsanordnung nach Anspruch 7, dadurch gekennzeichnet, dass die weiteren Datenwörter (B4, B5, B6, F2) ein Binärzeichen (B4) enthalten, das das jeweils letzte zu einem Zeichen gehörende weitere Datenwort (B4, B5, B6, F2) kennzeichnet.

9. Schaltungsanordnung nach einem der vorangehenden Ansprüche, dadurch gekenzeichnet, dass vorgegebene Kombinationen von Binärzeichen Steuerzeichen kennzeichnen und dass die Schaltstufe (SS) beim Auftreten dieser Kombinationen mindestens einen Teil der von der Tastatur (TA) abgegebenen Signale (S1) unter Umgehung der Speicher (SP1, SP2) zur Steuereinheit (ST) durchschaltet.

**Claims**

1. Circuit arrangement for converting characters, which can be typed in by means of a keyboard, into code characters, in particular telegraph characters, characterised in that there is provided a first store (SP1) which is connected to the keyboard (TA) and which contains a data word (B1, B2, B3, F1) for each character and in which in a character, which can be directly represented by a code character, this code character (F1) is contained and in which an adress word (AD2) is contained for each special character or symbol, for which no code character is present, and that there is provided a second store (SP2), to which the address word (AD2) is supplied and in which a plurality of further data words (B4, B5, B6, F2) are stored for each special character or symbol, which data symbol include code characters (F2) describing this character, and that there is provided a switching stage (SS) which when a character is typed-in connects either the code character (F1) contained in the data word (B1, B2, B3, F1) or the plurality of code characters (F2) contained in the further data word (B4, B5, B6, F2) through to a control unit (ST).

2. Circuit arrangement as claimed in claim 1, characterised in that the first store (SP1) for the data words (B1, B2, B3, F1) and the second store (SP2) for the further data words (B4, B5, B6, F2) are components of a single storage unit (SP).

3. Circuit arrangement as claimed in claim 1 or claim 2, characterised in that the stores (SP1, SP2) are designed as read only memories.

4. Circuit arrangement as claimed in one of claims 1 to 3, characterised in that the stores (SP1, SP2) and the switching stage (SS) are components of a microcomputer.

5. Circuit arrangement as claimed in one of claims 1 to 4, characterised in that the data words (B1, B2, B3, F1) contain a binary character (B1) which characterises each character for which no code character is available.

6. Circuit arrangement as claimed in one of claims 1 to 5, characterised in that each of the further data words (B4, B5, B6, F2) includes a plurality of code characters.

7. Circuit arrangment as claimed in one of claims 1 to 5, characterised in that each of the further data words (B4, B5, B6, F2) includes a code character (F2).

8. Circuit arrangement as claimed in claim 7, characterised in that the further data words (B4, B5, B6, F2) include a binary character (B4) which characterises the last further data word (B4, B5, B6, F2) assigned to a character.

9. Circuit arrangement as claimed in one of the preceding claims, characterised in that predetermined combinations of binary characters characterise control characters, and that when these combinations occur, the switching stage (SS) connects at least a share of the signals (SI) emitted by the keyboard (TA) through to the control unit (ST), by-passing the stores (SP1, SP2).

## Revendications

1. Montage pour convertir des caractères susceptibles d'être introduits à l'aide d'un clavier, en caractères de code, en particulier caractères de télescripteurs, caractérisé par le fait qu'il est prévu une première mémoire (SP1) reliée au clavier (TA) et comportant pour chaque caractère un mot de données (B1, B2, B3, F1), dans laquelle pour un caractère susceptible d'être directement représenté par un caractère de code, ce caractère de code (F1) est contenu, et dans laquelle, pour chaque caractère particulier ou symbole pour lequel il n'existe pas de caractère de code, est contenu un mot d'adresse (AD2), qu'il est prévu une seconde mémoire (SP2) au niveau de laquelle est présent le mot d'adresse(AD2) et dans laquelle sont mémorisés, pour chaque caractère particulier ou symbole, plusieurs autres mots de données (B4, B5, B6, F2) qui contiennent ce caractère de code (F2) descriptif de ce caractère, et qu'il est prévu un étage de commutation (SS) qui transmet à une unité de commande (ST), lors de l'introduction d'un caractère, soit le caractère de code (F1) qui est contenu dans le mot de données (B1, B2, B3, F1), soit la pluralité de caractères de code (F2) qui sont contenus dans les autres mots de code (B4, B5, B6, R2).

2. Montage selon la revendication 1, caractérisé par le fait que la première mémoire (SP1) pour les mots de données (B1, B2, B3, F1) et la seconde mémoire (SP2) pour les autres mots de données (B4, B5, B6, F2) sont des éléments constitutifs d'une unité de mémoire unique (SP).

3. Montage selon la revendication 1 ou la revendication 2, caractérisé par le fait que les mémoires (SP1, SP2) sont réalisées sous la forme de mémoires mortes.

4. Montage selon l'une des revendications 1 à 3, caractérisé par le fait que les mémoires (SP1, SP2) et l'étage de commutation (SS) sont des éléments constitutifs d'un micro-ordinateur.

5. Montage selon l'une des revendications 1 à 4, caractérisé par le fait que les mots de données (B1, B2, B3, F1) contiennent un chiffre binaire (B1) qui caractérise chaque caractère pour lequel un caractère de code n'est pas disponible.

6. Montage selon l'une des revendications 1 à 5, caractérisé par le fait que chacun des autres mots de données (B4, B5, B6, F2) contient une pluralité de caractères de codes.

7. Montage selon l'une de revendications 1 à 5, caractérisé par le fait que chacun des autres mots de données (B4, B5, B6, F2) contient un caractère de code (F2).

8. Montage selon la revendication 7, caractérisé par le fait que les autres mots de données (B4, B5, B6, F2) contiennent un chiffre binaire (B4) qui caractérise le dernier autre mot de données (B4, B5, B6, F2) qui appartient à un autre caractère.

9. Montage selon l'une des revendications précédentes, caractérisé par le fait que des combinaisons de chiffre binaires prédéterminées caractérisent des caractères de commande et que l'étage de commutation (SS), à l'apparition de ces combinaisons, transmet à l'unité de commande (ST) au moins une partie des caractères (S1) fournis par le clavier (TA) en contournant les mémoires (SP1, SP2).

# FIG 1

# FIG 2

| AD 1 | | | | | | | | B1 | B2 | B3 | F1 | | | | | | | |
|---|---|---|---|---|---|---|---|---|---|---|---|---|---|---|---|---|---|---|
| 1 | 0 | 0 | 0 | 1 | 0 | 1 | 1 | 0 | 1 | 0 | 1 | 0 | 1 | 0 | 1 | | | Y |
| 1 | 0 | 0 | 0 | 1 | 1 | 0 | 0 | 1 | 0 | 0 | 1 | 1 | 0 | 0 | 1 | | | § |
| 1 | 0 | 0 | 0 | 1 | 1 | 0 | 1 | 0 | 1 | 0 | 1 | 0 | 1 | 1 | 1 | | | Q |

# FIG 3

| AD 2 | | | | | | | B4 | B5 | B6 | F 2 | | | | | | |
|---|---|---|---|---|---|---|---|---|---|---|---|---|---|---|---|---|
| 0 | 0 | 1 | 1 | 0 | 0 | 1 | 1 | 0 | 0 | 1 | 0 | 1 | 1 | 0 | | p |
| 0 | 0 | 1 | 1 | 0 | 1 | 0 | 1 | 0 | 0 | 0 | 0 | 0 | 1 | 1 | | a |
| 0 | 0 | 1 | 1 | 0 | 1 | 1 | 0 | 0 | 0 | 0 | 1 | 0 | 1 | 0 | | r |